## Europäisches Patentamt

## European Patent Office

## Office européen des brevets

Veröffentlichungsnummer: **0 282 867**
**A1**

## EUROPÄISCHE PATENTANMELDUNG

Anmeldenummer: 88103525.7

Anmeldetag: 07.03.88

Int. Cl.⁴ **H05K 7/14** , H01H 1/40 ,
G06F 15/40

Priorität: 20.03.87 DE 3709117

Veröffentlichungstag der Anmeldung:
21.09.88 Patentblatt 88/38

Benannte Vertragsstaaten:
CH DE FR GB LI

Anmelder: **Siemens Aktiengesellschaft Berlin
und München**
**Wittelsbacherplatz 2**
**D-8000 München 2(DE)**

Erfinder: **Latussek, Hans-Peter, Dipl.-Ing.**
**Heideweg 77**
**D-8501 Feucht(DE)**
Erfinder: **Weber, Rolf, Dr.**
**Eggenweiherstrasse 18**
**D-8524 Neunkirchen(DE)**

Elektronische Baugruppe.

Die Erfindung bezieht sich auf eine elektronische Baugruppe (2), bestehend aus einer Leiterplatte (4) mit mehreren Signaleingängen und/oder -ausgängen und mit wenigstens einem aus mehreren Signalleitungen bestehenden Bus und einer Frontplatte (6). Erfindungsgemäß sind die Signaleingänge und/oder -ausgänge über ein mittels eines Handhabungsmittels (22) bewegbares vielpoliges Kontaktmittel (10) mit den korrespondierenden Signalleitungen des Busses elektrisch leitend verbindbar, wobei die Handhabe (26) des Handhabungsmittels (22) auf der Vorderseite (28) der Frontplatte (6) angeordnet ist. Somit kann jede beliebige Baugruppe (2) eines Baugruppenträgers von einem baugruppenübergreifenden Bus elektrisch getrennt werden, ohne dabei diese Baugruppe (2) aus ihrem Steckplatz des Baugruppenträgers herausziehen zu müssen.

FIG 1

## Elektronische Baugruppe

Die Erfindung bezieht sich auf eine elektronische Baugruppe, bestehend aus einer Leiterplatte mit mehreren Signaleingängen und oder -ausgängen und mit wenigstens einem aus mehreren Signalleitungen bestehenden Bus und einer Frontplatte.

Derartige elektronische Baugruppen sind im Handel erhältlich und sind in einem Baugruppenträger einschiebbar. Die elektronischen Baugruppen, beispielsweise eines Mikro-oder Minicomputersystems, werden mittels baugruppenübergreifender Signalleitungen auf der Rückwandleiterplatte eines Baugruppenträgers miteinander verbunden. Diese baugruppenübergreifenden Signalleitungen sind beispielsweise auch als VME-Bus bekannt. Dieser VME-Bus ist zuständig für den grundlegenden schnellen Datenverkehr zwischen den wichtigsten elektronischen Baugruppen dieses Bussystems. Je nach den verwendeten Systemkomponenten und der geforderten Leistungsfähigkeit variieren auch die Busstrukturen. Der Datenaustausch erfolgt beispielsweise im 8-, 16-oder 32-Bit-Format, d.h. es sind beispielsweise 8, 16 oder 32 baugruppenübergreifende Signalleitungen vorgesehen, die die einzelnen elektronischen Baugruppen eines Bussystems untereinander verbinden. Somit enthält jede elektronische Baugruppe 8, 16 oder 32 Signaleingänge und/oder -ausgänge und 8, 16 oder 32 Signalleitungen, die einen Baugruppenbus bilden. Außerdem enthält beispielsweise der VME-Bus neben dem Datenbus einen Adressbus und einen Steuerbus, die jeweils mehrere Busleitungen enthalten. Die Signaleingänge und/oder -ausgänge sind Bestandteil der verwendeten Messerleiste der elektronischen Baugruppen. Bei derartigen baugruppenübergreifenden Bussystemen kann ein Fehler, beispielsweise ein Kurzschluß eines Ausgangstreibers mit der Versorgungsspannung eines Busteilnehmers, das gesamte Bussystem blockieren. Eine Lokalisierung der defekten elektronischen Baugruppe ist bei vielen Fehlerarten mit Hilfe einer Diagnoseroutine möglich. Jedoch können einige Fehler nur dadurch ermittelt werden, daß nacheinander alle Baugruppen aus dem Baugruppenträger herausgezogen werden müssen, bis die defekte Baugruppe gefunden und damit die Störung behoben ist und der baugruppenübergreifende Bus der Rückwandleiterplatte nicht mehr gestört wird. Beim Herausziehen der einzelnen Baugruppen aus ihren Steckplätzen eines Baugruppenträgers wird die gesamte Funktion der herausgezogenen Baugruppe außer Betrieb gesetzt. Dies bringt eine erhebliche Einschränkung der Verfügbarkeit des Systems mit sich.

Der Erfindung liegt nun die Aufgabe zugrunde, Baugruppen der eingangs genannten Art so weiterzubilden, daß jede beliebige Baugruppe eines Baugruppenträgers von einem baugruppenübergreifenden Bus elektrisch getrennt werden kann, ohne dabei die Baugruppe selbst aus ihrem Steckplatz des Baugruppenträgers herausziehen zu müssen.

Diese Aufgabe wird erfindungsgemäß dadurch gelöst, daß die Signaleingänge und·oder -ausgänge über ein mittels eines Handhabungsmittels bewegbares vielpoliges Kontaktmittel mit den korrespondierenden Signalleitungen des Busses elektrisch leitend verbindbar sind, wobei die Handhabe des Handhabungsmittels auf der Vorderseite der Frontplatte angeordnet ist.

Dadurch, daß die Signaleingänge und/oder -ausgänge einer jeden Baugruppe über ein steuerbares Kontaktmittel mit den korrespondierenden Signalleitungen elektrisch leitend verbindbar sind, kann man jede beliebige an einem baugruppenübergreifenden Bus angeschlossene Baugruppe von diesem Bus elektrisch trennen, ohne dabei diese Baugruppe aus ihrem Steckplatz eines Baugruppenträgers herausziehen zu müssen. Dieses Kontaktmittel wird mittels eines Handhabungsmittels betätigt, wobei die Handhabe jeweils auf der Vorderseite der Frontplatte einer jeden Baugruppe angeordnet ist. Somit kann man durch eine Trennbewegung der Handhabe auf der Vorderseite der Frontplatte einer jeden Baugruppe mehrere Signalleitungen gleichzeitig von den Signaleingängen und/oder -ausgängen auf der der Frontplatte gegenüberliegenden Seite, nämlich der Steckseite, elektrisch trennen, ohne dabei diese Baugruppe aus ihrem Steckplatz des Baugruppenträgers herausziehen zu müssen.

In einer vorteilhaften Ausführungsform der Baugruppe ist das Handhabungsmittel von der Vorderseite der Frontplatte in das Kontaktmittel einführbar und die Leiterplatte ist mit einem Führungsmittel für das Handhabungsmittel versehen. Somit ist gewährleistet, daß nur im Falle einer Störung jede beliebige Baugruppe eines Bussystems vom baugruppenübergreifenden Bus elektrisch getrennt werden kann. Außerdem benötigt man nur für jede störende Baugruppe ein Handhabungsmittel, d.h. man trennt mittels eines Handhabungsmittels nacheinander die Baugruppen vom baugruppenübergreifenden Bus, wobei in Verbindung mit einer geeigneten Testroutine festgestellt wird, bei welcher Baugruppe die Blockierung des Busses behoben ist. Bei nur einer störenden Baugruppe benötigt man somit nur ein Handhabungsmittel. Außerdem sind die Baugruppen nur durch berechtigte Personen vom Bus trennbar.

Weitere Ausgestaltungen des bewegbaren Kontaktmittels sind gekennzeichnet durch die Merkmale der Unteransprüche 3 bis 5.

Zur weiteren Erläuterung der Erfindung wird auf die Zeichnung Bezug genommen, in der Ausführungsbeispiele nach der Erfindung schematisch veranschaulicht sind.

FIG 1 zeigt einen Längsschnitt durch eine erfindungsgemäße elektronische Baugruppe, die

FIG 2 zeigt ein bewegbares Kontaktmittel mit einem Handhabungsmittel nach FIG 1, die

FIG 3 stellt einen Längsschnitt durch eine weitere Ausführungsform einer elektronischen Baugruppe dar, die

FIG 4 veranschaulicht einen Querschnitt durch die Baugruppe gemäß der FIG 3, die

FIG 5 zeigt einen Längsschnitt durch eine einfache Ausführungsform einer elektronischen Baugruppe und die

FIG 6 zeigt einen Längsschnitt durch eine vorteilhafte Ausführungsform einer erfindungsgemäßen Baugruppe.

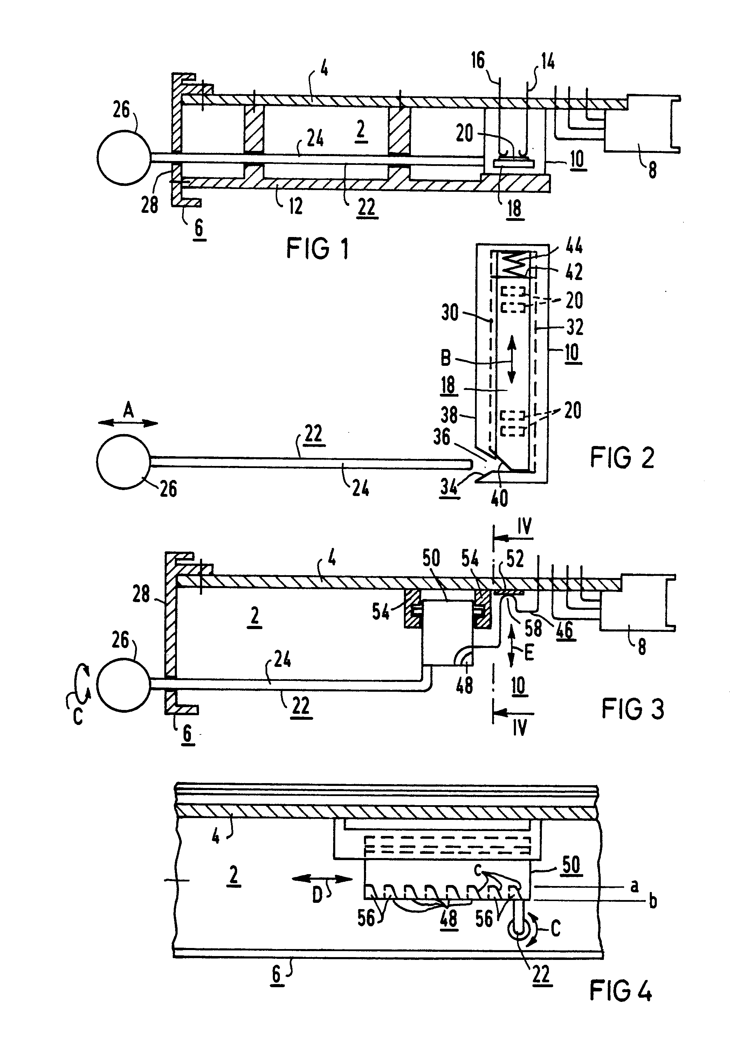

Die FIG 1 zeigt eine elektronische Baugruppe 2, bestehend aus einer Leiterplatte 4, einer Frontplatte 6 und einer Messerleiste 8. Außerdem ist die Leiterplatte 4 der Baugruppe 2 mit einem vielpoligen bewegbaren Kontaktmittel 10 und mit einem Führungsmittel 12 versehen. Das Kontaktmittel 10 enthält jeweils eine Reihe von Eingangskontaktstiften 14 und Ausgangskontaktstiften 16 und einen bewegbaren Steg 18 mit parallel angeordneten Kontaktzungen 20. Mit Hilfe dieser Kontaktzungen 20 sind jeweils ein Eingangskontaktstift 14 mit einem Ausgangskontaktstift 16 elektrisch leitend verbindbar. Die Kontaktstifte 14 und 16 des Kontaktmittels 10 und die Kontaktzungen 20 des Stegs 18 sind derartig ausgestaltet, daß mittels der Öffnungsbewegung des Steges 18 die Kontakte 14, 16 und 20 sich selbst reinigen, d.h. mittels einer Kratzbewegung eine entstandene Oxidschicht abgetragen wird. Deshalb sind die freien Enden der Kontaktstifte 14 und 16 als Kontaktnasen ausgebildet. Besonders vorteilhaft ist es, wenn die Kontaktstifte 14 und 16 zwischen den in der Leiterplatte 4 befestigten Enden und den Kontaktnasen als Federn ausgebildet sind, so daß die Kontaktnasen gegen die Kontaktzungen 20 des Steges 18 gedrückt werden, damit der Übergangswiderstand klein ist und immer eine gute elektrisch leitende Verbindung gewährleistet wird. Der Steg 18 des Kontaktmittels 10 ist mittels eines Handhabungsmittels 22 bewegbar. Das Handhabungsmittel 22 besteht aus einem Trennteil 24, auch als Schub- oder Torsionsstange bezeichnet, und aus einer Handhabe 26. Das Trennteil 24 ist in dem Führungsmittel 12 geführt. Das eine Ende des Trennteils 24 ist mit dem Kontaktmittel 10 verbunden. Die Handhabe 26 des Handhabungsmittels 22 ist auf der Vorderseite 28 der Frontplatte 6 angeordnet. Außerdem sind die Eingangskontaktstifte 14 mit den Signaleingängen und/oder -ausgängen der Baugruppe 2 elektrisch leitend verbunden. Die Signaleingänge und/oder -ausgänge der Baugruppe 2 sind Bestandteil der verwendeten Messerleiste 8.

Wenn der Datenaustausch zwischen den einzelnen Baugruppen 2 eines Bussystems, beispielsweise in einem 16-Bit-Formt erfolgt, so enthält die Rückwandleiterplatte des Bussystems einen 16-strängigen baugruppenübergreifenden Bus und jede Baugruppe 2 sechzehn Signaleingänge und/oder -ausgänge, d.h. sechzehn Messerkontakte der beispielsweise 96-poligen Messerleiste 8. Diese sechzehn Signaleingänge und/oder -ausgänge sind mit sechzehn Eingangskontaktstiften 14 des Kontaktmittels 10 elektrisch leitend verbunden, dessen sechzehn Ausgangskontaktstifte 16 mit sechzehn Signalleitungen des Busses der Baugruppe 2 elektrisch leitend verbunden sind. Wenn das Bussystem redundant aufgebaut ist, enthält jede Baugruppe 2 zwei Kontaktmittel 10, die jeweils beispielsweise sechzehn Eingangs-und Ausgangskontaktstifte 14 und 16 haben.

Im betriebsgemäßen Zustand eines Bussystems sind alle Baugruppen 2 in einen Baugruppenträger gesteckt und an einen ersten Bus dadurch angeschlossen, daß bei jedem ersten Kontaktmittel 10 die Eingangskontaktstifte 14 mit den Ausgangskontaktstiften 16 mittels der Kontaktzungen 20 des Steges 18 verbunden sind. Der Datenverkehr zwischen den einzelnen Baugruppen 2 des Bussystems erfolgt auf dem ersten baugruppenübergreifenden Bus. Wenn nun ein Fehler auftritt, der diesen Bus stört, kann auf den redundanten Bus umgeschaltet werden. Dadurch bleibt trotz eines auftretenden Fehlers das System in Betrieb. Die Fehlersuche erfolgt nun auf dem gestörten ersten Bus, indem man nacheinander die Baugruppen 2 jeweils mittels des über das Handhabungsmittel 22 betätigbare Kontaktmittel 10 vom gestörten ersten Bus trennt. In Verbindung mit einer geeigneten Testroutine wird festgestellt, bei welcher Baugruppe 2 die Blockierung des Busses behoben ist. Die so lokalisierte defekte Baugruppe 2 kann nun ausgetauscht werden. Durch diese indirekte Ankopplung der Baugruppen 2 an die baugruppenübergreifenden Busse können jederzeit einzelne Baugruppen 2 von einem Bus getrennt werden, ohne dabei die Baugruppe aus ihrem Steckplatz eines Baugruppenträgers herausziehen und ohne dabei das System abschalten zu müssen. Auch auf der Verdrahtungsseite der Rückwandleiterplatte des Baugruppenträgers braucht man keinen Eingriff vornehmen, sondern kann jeweils mittels der Handhabe 26 des Handhabungsmittels 22 auf der Vorderseite 28 der Frontplatte 6 einer jeden Baugruppe 2 diese Baugruppe 2 von einem Bus trennen. Somit wird die Verfügbarkeit des System nicht eingeschränkt.

Die FIG 2 zeigt eine Draufsicht eines vielpoligen bewegbaren Kontaktmittels 10 nach FIG 1 mit dem Handhabungsmittel 22. Der Steg 18 des Kontaktmittels 10 wird in Führungen 30 und 32 geführt. Außerdem hat der Steg 18 auf der den Kontaktnasen der Eingangs-bzw. Ausgangskontaktstiften 14 bzw. 16 mehrere Kontaktzungen 20, die jeweils durch eine unterbrochene Linie angedeutet sind. Diese Kontaktzungen 20 sind zueinander parallel angeordnet. An einem Ende des Kontaktmittels 10 ist eine Fangeinrichtung 34 vorhanden, in der das Trennteil 24 des Handhabungsmittels 22 eingreifen kann. Die Öffnung 36 der Fangeinrichtung 34 befindet sich auf einer Längsseite 38 des Kontaktmittels 10, wobei die Kanten abgeschrägt sind. Die Stirnseite 40 des Steges 18 im Bereich der Fangeinrichtung 34 ist ebenfalls derart angeschrägt, daß die dem Handhabungsmittel zugewandte Längsseite des Steges 18 kürzer ist als die abgewandte Längsseite des Steges 18. Außerdem ist die Öffnung 36 der Fangeinrichtung 34 des Kontaktmittels 10 und die abgeschrägte Stirnseite 40 abhängig vom Durchmesser des Trennteils 24 des Handhabungsmittels 22. Die Schräge der Stirnseite 40 des Steges 18 bestimmt die Öffnungsbewegung der Kontakte 14, 16 und 20. Durch diese dargestellte Ausführungsform des Kontaktmittels 10 wird erreicht, daß eine Trennbewegung der Handhabe 26 parallel zur Leiterplatte 4, gekennzeichnet durch einen Doppelpfeil A, in eine Öffnungsbewegung des Steges 18, gekennzeichnet durch einen Doppelpfeil B, parallel zur Leiterplatte 3 und rechtwinklig zur Trennbewegung A sich ändert. Da die der abgeschrägten Stirnseite 40 gegenüberliegende Stirnseite 42 mit einer Feder 44 versehen ist, gelangt der Steg 18 immer wieder in den geschlossenen Betriebszustand, sobald das Handhabungsmittel 22 aus einer Arretierung in der Frontplatte 6 der Baugruppe 2 oder sogar aus dem Kontaktmittel 10 gezogen wird. Da das Handhabungsmittel 22 mit dem Kontaktmittel 10 mittels des Führungselementes 12 verbindbar ist, kann jeweils die Baugruppe 2 nur von befugten Personen von einem baugruppenübergreifenden Bus getrennt werden.

Die FIG 3 zeigt eine weitere Ausgestaltung des Kontaktmittels 10 auf der Leiterplatte 4 der Baugruppe 2. Als Kontaktmittel 10 sind mehrere nebeneinander angeordnete federnde Kontakte 46 vorgesehen, die einerseits mit der Leiterplatte 4 im Bereich der Messerleiste 8 verbunden sind und andererseits sich jeweils auf korrespondierende Segmente 48 eines Gleitsteins 50 und auf Kontaktzungen 52 auf der Leiterplatte 4 abstützen. Der Gleitstein 50 wird mit Hilfe einer Kulisse 54 geführt. Die Kontaktzungen 52 sind jeweils mit den Signalleitungen des Busses auf der Baugruppe 2 verbunden. Außerdem sind jeweils die Enden der federnden Kontakte 46 mit den Signaleingängen und/oder -ausgängen, die eine Untermenge der Messerkontakte der Messerleiste 8 sind, elektrisch leitend verbunden. Der Gleitstein 50 ist mittels des Handhabungsmittels 22 verschiebbar. Dabei ist das Trennteil 24 des Handhabungsmittels 22 mit dem Gleitstein 50 verknüpft und die Handhabe 26 ist auf der Vorderseite 28 der Frontplatte 6 der Baugruppe 2 angeordnet.

In der FIG 4 ist ein Querschnitt IV-IV der Baugruppe 2 gemäß FIG 3 dargestellt. Der Gleitstein 50, der in der Kulisse 54 geführt wird, ist in einzelne Segmente 48 unterteilt. Die korrespondierenden Flächen 56 der Segmente 48, auf denen sich die federnden Kontakte 46 abstützen, sind derartig ausgestaltet, daß jeweils die federnden Kontakte 46 in zwei stabilen Punkten a und b, die unterschiedliches Niveau haben, verharren können und daß jeweils als Verbindung zwischen diesen beiden stabilen Punkten a und b eine Rampe c vorgesehen ist. Wenn nun das Handhabungsmittel 22 eine Drehbewegung, gekennzeichnet durch einen Doppelpfeil C, ausführt, bewegt sich der Gleitstein 50 innerhalb der Kulisse 54 parallel zur Frontplatte 6 der Baugruppe 2, gekennzeichnet durch einen Doppelpfeil D. Dadurch gelangen jeweils die federnden Kontakte 46 aus dem stabilen Punkt a in den stabilen Punkt b, wodurch jeweils die Kontaktnase 58 sich von den Kontaktzungen 52 abheben. Diese Abhebbewegung der Kontaktnasen 58 ist in der FIG 3 durch einen Doppelpfeil E gekennzeichnet.

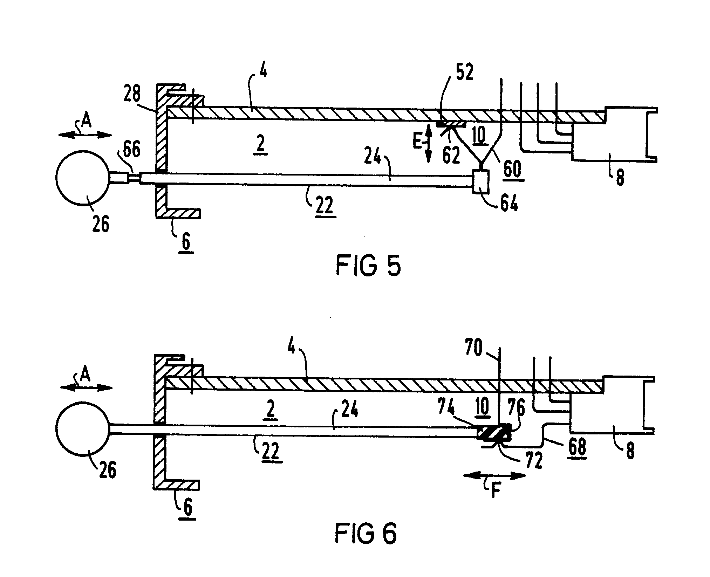

Die FIG 5 zeigt eine besonders vorteilhafte einfache Ausführungsform des Kontaktmittels 10. Als Kontaktmittel 10 sind mehrere nebeneinander angeordnete federnde Kontakte 60 vorgesehen, die mit der Leiterplatte 4 der Baugruppe 2 verbunden sind und deren Kontaktnasen 62 sich jeweils auf eine Kontaktzunge 52 der Leiterplatte 4 abstützen. Alle federnden Kontakte 60 sind mittels eines Steges 64 aus Isoliermaterial miteinander verbunden. Auch bei dieser Ausführungsform sind die Kontaktzungen 52 jeweils mit den Signalleitungen des Busses auf der Leiterplatte 4 elektrisch leitend verbunden und die mit der Leiterplatte 4 verbundenen Enden der federnden Kontakte 60 sind elektrisch leitend mit den Signaleingängen und/oder -ausgängen der Messerleiste 8 verknüpft. Das Handhabungsmittel 22 ist mit seinem Trennteil 24 mit dem Steg 64 verbunden, wobei die Handhabe 26 auf der Vorderseite 28 der Frontplatte 6 der Baugruppe 2 angeordnet ist. Außerdem ist das Trennteil 24, das auf der Vorderseite 28 der Frontplatte 6 angeordnet ist, mit einer Einkerbung 66 versehen, damit man das Handhabungsmittel 22 in der Frontplatte 6 arretieren kann. Wenn nun die Handhabe 24, gemäß dem Doppelpfeil A. bewegt wird. ändert sich diese Bewegung jeweils in eine Abhebbewegung der Kontaktnasen 62. gekennzeichnet durch einen Doppelpfeil E. Somit kann man jederzeit beliebige Baugruppen 2 von einem baugruppenübergreifenden Bus eines Systems elektrisch trennen, ohne dabei diese Baugruppe 2 aus ihrem Steckplatz des Baugruppenträgers herausziehen zu müssen.

In der FIG 6 ist eine weitere Ausführungsform des Kontaktmittels 10 veranschaulicht. Dabei wird das vielpolige Kontaktmittel 10 aus mehreren nebeneinander angeordneten Kontakten 68 der Messerleiste 8 und aus mehreren nebeneinander angeordneten Kontakten 70, die mit der Leiterplatte 4 verknüpft sind. gebildet. Dabei sind die Kontakte 68 jeweils mit einer Kontaktnase 72 versehen. Die federnden Kontakte 70 sind mittels eines Quersteges 74 miteinander verbunden. Dabei ist der Quersteg 74 mit parallel angeordneten Kontaktzungen 76 versehen, die jeweils die federnden Kontakte 70 mit den Auflageflächen der Kontaktnasen 72 elektrisch leitend verbinden. Außerdem ist der Steg 74 mit dem Trennteil 24 des Handhabungsmittels 22 verbunden. Wenn man die Handhabe 26 des Handhabungsmittels 22, gemäß dem Doppelpfeil A, bewegt, so bewegen sich die federnden Kontakte 70 gemäß dem Doppelpfeil F. Beide Bewegungen A und F verlaufen in derselben Richtung, d.h. man hat hier keine Kraftumlenkung.

## Ansprüche

1. Elektronische Baugruppe (2), bestehend aus einer Leiterplatte (4) mit mehreren Signaleingängen und/oder -ausgängen und mit wenigstens einem aus mehreren Signalleitungen bestehenden Bus und einer Frontplatte (6), **dadurch gekennzeichnet**, daß die Signaleingänge und/oder -ausgänge über ein mittels eines Handhabungsmittels (22) bewegbares vielpoliges Kontaktmittel (10) mit den korrespondierenden Signalleitungen des Busses elektrisch leitend verbindbar sind, wobei die Handhabe (26) des Handhabungsmittels (22) auf der Vorderseite (28) der Frontplatte (6) angeordnet ist.

2. Elektronische Baugruppe (2) nach Anspruch 1, **dadurch gekennzeichnet**, daß das Handhabungsmittel (22) von der Vorderseite (28) der Frontplatte (6) in das Kontaktmittel (10) einführbar ist, und daß die Leiterplatte (4) mit einem Führungsmittel (12) für das Handhabungsmittel (22) versehen ist.

3. Elektronische Baugruppe (2) nach Anspruch 1, **dadurch gekennzeichnet**, daß als Kontaktmittel (10) ein Mehrfachschalter vorgesehen ist, dessen Eingangs-bzw. Ausgangskontaktstifte (14 bzw. 16) jeweils in einer Reihe und einander gegenüber angeordnet sind und die mittels Kontaktzungen (20), die auf einem bewegbaren in Führungen (30, 32) geführten Steg (18) parallel angeordnet sind, miteinander elektrisch leitend verbindbar sind, daß der Mehrfachschalter derart mit einem Fangbereich (34) für das Handhabungsmittel (22) versehen ist, daß die Trennbewegung (A) des Handhabungsmittels (22) sich in eine Öffnungsbewegung (B) der parallel angeordneten Kontaktstifte (14, 16, 20) ändert, und daß der Steg (18) am gegenüberliegenden Ende des Fangbereichs (34) mit einer Feder (44) versehen ist.

4. Elektronische Baugruppe (2) nach Anspruch 1, **dadurch gekennzeichnet**, daß als Kontaktmittel (10) mehrere nebeneinander angeordnete federnde Kontakte (46) vorgesehen sind, die einerseits mit der Leiterplatte (4) im Bereich der Signaleingänge und/oder -ausgänge verbunden sind und andererseits sich auf die korrespondierenden Segmente (48) eines in eine Kulisse (54) geführten Gleitsteins (50) und auf Kontaktzungen (52) der Leiterplatte (4) abstützen, wobei die Segmente (48) des Gleitsteins (50) jeweils derart gestaltet sind, daß die Trennbewegung (C) des Handhabungsmittels (22) sich jeweils in eine Abhebbewegung (E) der federnden Kontakte (46) sich ändert, und daß die Kontaktzungen (52) mit den zu den Signaleingängen und/oder -ausgängen korrespondierenden Signalleitung elektrisch leitend verbunden sind.

5. Elektronische Baugruppe (2) nach Anspruch 1, **dadurch gekennzeichnet**, daß als Kontaktmittel (10) mehrere nebeneinander angeordnete federnde Kontakte (60) vorgesehen sind, die jeweils einerseits mit der Leiterplatte (4) im Bereich der Signaleingänge und/oder -ausgänge verbunden sind und andererseits jeweils sich auf Kontaktzungen (52) der Leiterplatte (4) abstützen, wobei die Kontaktzungen (52) mit den zu den Signaleingängen und/oder -ausgängen korrespondierenden Signalleitungen elektrisch leitend verbunden sind, und daß die federnden Kontakte (60) mittels eines Steges (64) aus Isoliermaterial miteinander verbunden sind.

FIG 1

FIG 2

FIG 3

FIG 4

**FIG 5**

**FIG 6**

**Europäisches Patentamt**

# EUROPÄISCHER RECHERCHENBERICHT

Nummer der Anmeldung

EP 88 10 3525

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US-A-4 395 610 (DOWNS et al.) <br> * Spalte 5, Zeile 45 - Spalte 6, Zeile 10 * | 1 | H 05 K 7/14 <br> H 01 H 1/40 <br> G 06 F 15/40 |
| Y | | 3,5 | |
| | --- | | |
| Y | US-A-4 476 357 (MALMBORG) <br> * Spalte 2, Zeilen 33-64 * | 3 | |
| | --- | | |
| Y | US-A-3 188 435 (RUGSTEN) <br> * Spalte 2, Zeilen 24-37 * | 5 | |
| | --- | | |
| A | US-A-3 525 828 (ECKHART et al.) <br> * Spalte 2, Zeilen 17-28 * | 4 | |
| | --- | | |
| A | DE-A-1 690 332 (TELEFUNKEN) <br> * Patentanspruch 1 * | 4 | |
| | ----- | | |

**RECHERCHIERTE SACHGEBIETE (Int. Cl.4)**

H 05 K
H 01 H
G 06 F

Der vorliegende Recherchenbericht wurde für alle Patentansprüche erstellt

| Recherchenort | Abschlußdatum der Recherche | Prüfer |
|---|---|---|
| DEN HAAG | 25-05-1988 | TOUSSAINT F.M.A. |